# EUROPEAN PATENT APPLICATION

(11) **EP 1 059 836 A1**
(43) Date of publication of application: **13.12.2000**
(21) Application number: 00103938.7
(22) Date of filing: 25.02.2000
(51) Int. Cl.: H05K 13/00, B65G 47/91

(54) **Loading device for finished and unfinished printed circuits and related method**

(30) Priority: 09.06.1999 IT MI991280
(71) Applicant: Pola & Massa S.r.l., 15076 Ovada (Alessandria) (IT)
(72) Inventor: Vacca, Sebastiano, 15076 Ovada (Alessandria) (IT)
(74) Representative: Petruzziello, Aldo

(57) **Abstract**

A loading device (100) for finished and unfinished printed circuits, comprising a container (2) in which one or more packs (4) of printed circuits (12) are positioned alongside each other, arranged slightly inclined with respect to a vertical plane (Y), said pack (4) is positioned toward a plurality of serrated blades (11) which engage on the top edge of the printed circuit(s) (12) foremost in the pile, to tip it/them onto a conveyor belt (18) that conveys said printed circuits toward operating machines situated downstream of the loading device (100).

## Description

The present invention refers to a loading device for finished and unfinished printed circuits and relative automatic method for loading said printed circuits toward operating machines situated downstream of said loading device.

In the final stages of manufacture, different types of printed circuits undergo blocking out, drilling, internal milling, etc. The residues of these operations (fiberglass-reinforced plastic dust and other substances) must be removed and the boards or plates that form the printed circuit must be washed with specific machines. The printed circuit boards are fed toward the washing machines by means of automatic loaders or manually.

For automatic loading in general, the boards we arranged in horizontal stacks and are picked up by suction means in order to be fed to the washing machine. This is not a simple operation. In fact, as stated above, the printed boards have holes of various shapes and are covered with dust. For this reason the various known gripping systems with suction cups or through vacuum formation are not very effective.

For example, using vacuum systems there is a risk of picking up more than one board at a time through the effect of the suction cup which propagates through the holes in the boards placed at the top of the stack; or else it can happen that no board is picked up because there are not enough free spaces on its surface to allow gripping by the suction cups or because the suction cups interfere with milled parts or holes that compromise their gripping effect.

The object of the present invention is to eliminate these drawbacks by providing a loading device for finished or unfinished printed circuits that is versatile, practical, safe and effective.

Another object of the present invention is to provide an automatic loading method for printed circuits that is extremely fast and precise.

These objects are achieved, in accordance with the invention, with the loading device for printed circuits according to independent claim 1 and with the loading method for printed circuits according to independent claim 8, respectively.

Preferred embodiments of the invention are apparent from the dependent claims.

The loading device for finished and unfinished printed circuits according to the invention provides for printed circuit boards to be disposed on edge on a special container and rest on a comb-shaped movable surface. Said container is made to advance beneath a support that supports a plurality of serrated, horizontally pivoted blades, operated by systems with a hydraulic or pneumatic actuator. The teeth of the blades engage the top of the outermost printed circuit and cause it to rotate around its lower edge which continues to rest on the base of the container.

When the board reaches a position parallel to the vertical axis, the blades that engage it are raised, thus causing release of the board which, though the force of gravity tips over onto a conveyor belt that feeds the boards toward a cleaning machine.

Such a system proves particularly suitable for printed circuit boards that have structural shapes with incisions, milled parts or holes that make them difficult to be loaded automatically with known means such as suction cups. Furthermore, said system proves extremely versatile, being independent of the shapes and sizes of the boards.

Further characteristics of the invention will be made clearer by the detailed description that follows, referring to a purely exemplary and therefore non-limiting embodiment thereof, illustrated in the appended drawings, in which:
Figure 1 is a side elevation of the loading device for printed circuit boards according to the invention; boards of different size are drawn and the device is drawn in different positions;

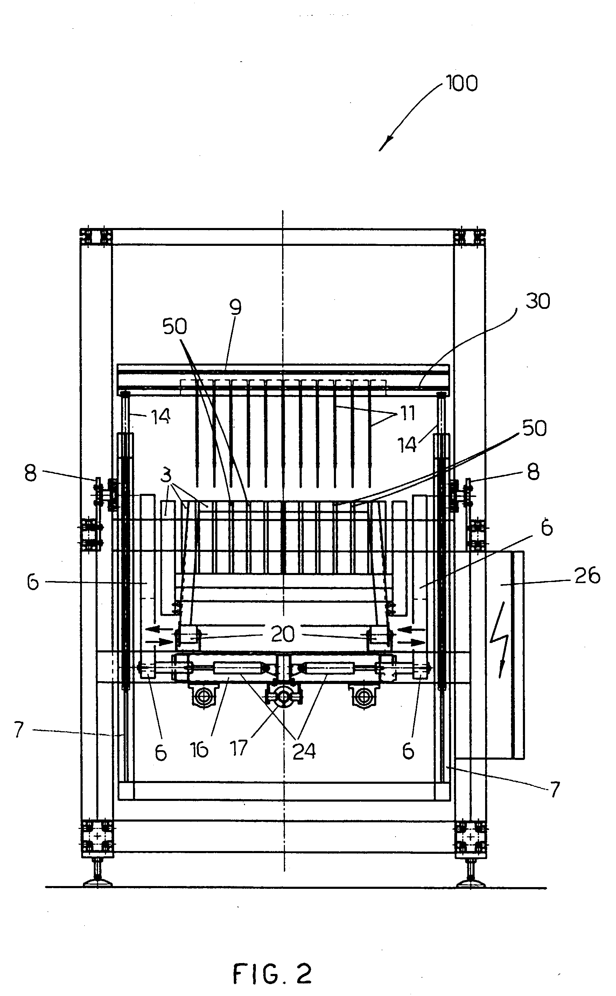

Figure 2 is a view from the right of the loading device for printed circuit boards in Figure 1, in which, for greater clarity, some parts have been removed.

A loading device for printed circuits according to the invention, denoted as a whole with reference numeral 100, is described with the aid of the figures.

The loading device 100 comprises a container 2 inside which is situated a mobile surface 3 resting against the rear wall of the container 2. The mobile surface 3 is made like a comb and has a plurality of slits 50. Inside the container printed circuit boards 12 are positioned on edge, so as to form one or more packs 4 of printed circuits arranged slantwise, in which the rear printed circuit rests on the mobile surface 3. The abutment surface of the mobile surface 3 is at an angle with respect to a vertical plane indicated by Y. In this manner the boards 12 of the pack 4 are inclined by an angle ϑ with respect to said vertical plane Y.

In an initial situation, the container 2 is on a carriage 1 supported by swivel wheels 52.

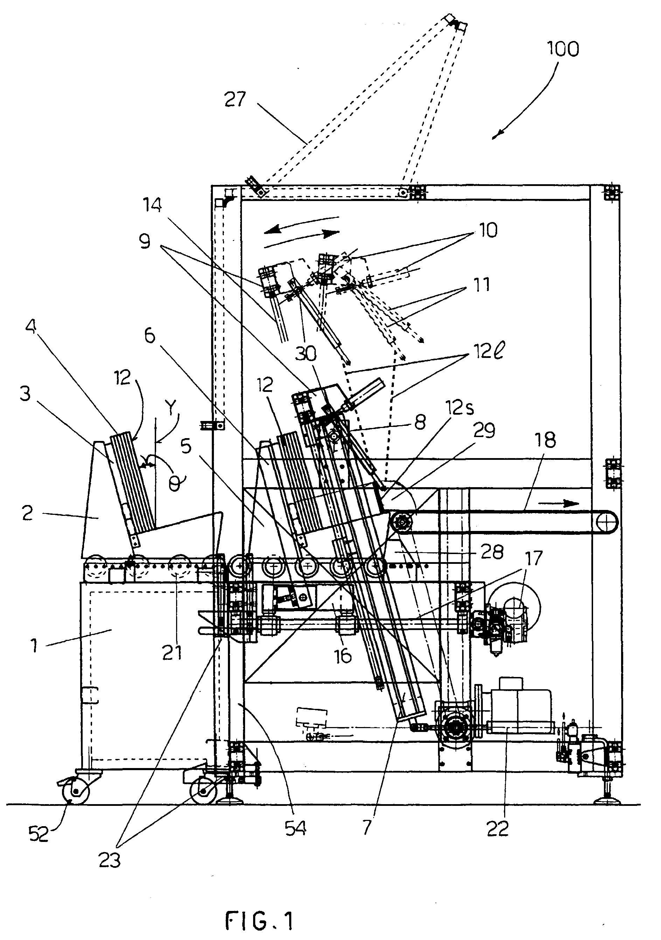

After raising of a cover 27 of the loading device 100, the carriage 1 is made to advance toward the entry of the loading device 100 and is automatically locked, with special serrated pins 23, to the frame 54 of the loading device, as shown in Figure 1.

Manually or automatically, the container 2 is made to slide on a system of rollers 21, as far as a stop ledge 28 inside the loading device 100. At this point, the carriage 1 is unlocked by means of a special unlocking pedal and is made to withdraw a sufficient amount to close the cover 27. With unlocking of the carriage 1, locking of the container 2 inside the loading device 100 takes place simultaneously. At this point the loading device 100 is ready to begin the loading cycle.

In the locking position of the container 2, two fork-shaped arms 6 operated by two pneumatic cylinders 24 are provided to hook the side ends of the comb-shaped surface 3. The fork-shaped arms 6 are mounted on a horizontally sliding slide 16, operated by a geared motor with screw 17, to allow the comb-shaped surface 3 to travel forward toward a loading position.

In the loading position, above the comb-shaped surface 3, is positioned a blade-holding head 9 formed by a horizontal crosspiece supported at its ends by two pistons 14. The pistons 14 are mounted respectively on two horizontally pivoted levers or cylinders 7 pivoted at respective points 8 of the frame and operated by a pneumatic cylinder 22.

Each piston 14 can be extended or retracted on its lever or cylinder 7, depending on the board size whereon it is intended to operate. In Figure 1 a small size board is referenced 12s, and the head 9 and members annexed thereto are drawn by thick lines in a retracted position to operate thereon. Dash lines referenced 12ℓ refer to large boards, and two positions of the head 9 to operate thereon are drawn by thin lines and dash lines, respectively.

The blade-holding head 9 supports a plurality of rod or blades 11, preferably having a rough surface, or a hack-saw shaped surface. The number of blades 11 is preferably the same as the number of slits 50 in the moveable surface 3. The blades 11 are constrained, pendulum-fashion, along a horizontal axis 30 of the blade-holding head 9 and can be raised or rotated for an angle all together by means of a pneumatic device 10.

The loading procedure for the printed circuits 12 will now be described.

After having set the correct positioning of the blade-holding head 9 corresponding to the height of the printed circuits 12 by means of a geared motor (not shown), the operator activates a pushbutton on the control panel that starts off the following cycles:
- The actuators 24 that push the respective arms 6 toward the center of the machine are operated so that they are inserted in two protruding extremities of the mobile comb-shaped surface 3.
- The geared motor 17 that causes forward movement of the slide 16 integral with the fork-shaped arms 6 that have hooked the mobile surface 3 is operated. This results in forward movement of the pack of circuits 4 due to the thrust of the mobile surface 3. This forward movement stops when the printed circuit 12 foremost in the pack 4 is detected by a photocell 29. At this point the end circuit 12 (a large circuit 12ℓ is shown in dash line), or a plurality of end circuits (if there are a number of small-sized packs close together) come into contact with the teeth of a series of blades 11.
- A pneumatic cylinder 22 is operated to make the horizontally pivoted levers 7 turn around the fulcrum 8. Consequently the printed circuit 12 is moved angularly thanks to the engagement of the blades 11 in its top part. This movement stops when the circuit 12 has gone beyond the vertical plane Y.
- The pneumatic device 10 is operated to rotate the blades for an angle around the axis of fulcrum 30, so as to release the printed circuit 12 which, thanks to force of gravity, is tipped onto a conveyor belt 18 which directs it toward a washing machine downstream of the loading device 100. The rhythm can be regulated according to the size of the boards and the speed of the machines downstream.
- Operations for unloading of the boards (12) follow one another until the pack 4 is finished.
- After unloading of the last board, the blades 11 are free to enter by gravity into the various incisions 50 of the comb-shaped mobile surface 3. After unloading of the last board, the unloading sequence is repeated three times to ensure that there are no plates 12 left in the container 2.
- The geared motor with screw 17 is operated to cause the slide 16 to retract so that the fork-shaped arms 6 bring back the mobile surface 3 until it abuts against the rear part of the container 2.
- The pneumatic cylinders 24 are operated to move the fork-shaped arms 6 away from the mobile surface 3 in order to free it.
- An acoustic or luminous signal warns the operator that he must replace the empty container 2 with another full one and reset the cycle.

From this description it appears obvious that the loading device 100 performs its functions, independently of the shape and size of the printed circuit boards.

Changes or modifications to this embodiment, within the reach of a person skilled in the art, nevertheless fall within the scope of the invention expressed by the appended claims.

## Claims

1. A loading device (100) for finished and unfinished printed circuits (12), comprising feeding means (2) for feeding said printed circuits (12), arranged stacked in packs (4), and engaging means (11) able to bring said printed circuits (12), one a time, onto a conveyor belt (18) to direct them toward other operating machines, characterized in that said feed means provide for a container (2) able to contain said pack/s (4) of printed circuits (12) in a slightly inclined position with respect to a vertical plane (Y) and that said engaging means are blades (11) operating on a top edge of a printed circuit(s) foremost in the stack, to tip it/them onto said conveyor belt (18).

2. A device according to claim 1, characterized in that said blades (11) are serrated blades and are hinged on an axis (30) of a blade-holding head (9) mounted on horizontally pivoted levers (7) able to cause a movement of the blade-holding head (9) such that the blades (11) can engage the upper part of the printed circuit(s) (12) foremost in the stack, as it/they rotate/s around its/their bottom edge until it/they go beyond the position of the vertical plane (Y).

3. A device according to claim 1 or 2, characterized in that actuator means (10) are provided such as to raise the blades (11) to obtain their disengagement from the printed circuit(s) (12), when the plane of the printed circuit has gone beyond the position of the vertical plane (Y).

4. A device according to any one of the preceding claims, characterized in that inside said container (2) a comb-shaped mobile surface (3) is provided on which the pack (4) of printed circuits rests, said mobile surface (3) being able to push the pack of printed circuits toward said blades (11).

5. A device according to claim 4, characterized in that two fork-shaped arms (6) are provided such as to grip said mobile surface (3) laterally to push it toward the blades (11).

6. A device according to claim 5 characterized in that said fork-shaped arms (6) are operated by means of respective actuators (24) and are mounted on a horizontally sliding slide (16).

7. A device according to claim 6, characterized in that said slide (16) is operated by a geared motor with screw (17).

8. A loading method for printed circuits comprising the following steps:
- feeding a pack (4) of printed circuits (12), stacked on edge, toward a loading device (100);
- tipping the printed circuit(s) (12) foremost in the pack (4) onto a conveyor belt (18), through engagement of the serrated blades (11) on the upper edge of said circuit(s) (12).

9. A method according to claim 8, characterized in that said step of feeding the pack (4) of printed circuits toward the loading devices comprises the following steps:
- positioning the pack (4) of printed circuits in a container (2) so that the last circuit rests on a mobile comb-shaped surface (3);
- moving forward of said mobile surface (3) which pushes the pack (4) until the foremost printed circuit(s) (12) reach(es) a limit switch detected by detector means (29).

10. A method according to claim 8 or 9 , characterized in that said step of tipping the printed circuit(s) (12) foremost in the pack (4) comprises the following steps:
- angular movement of the supporting means (7) of said blades (11) engaged with the top edge of the printed circuit(s) (12), so as to cause an angular movement of the printed circuit(s) (12) which, resting on its/their bottom edge, rotate beyond its/their vertical position;
- angular movement of the blades (11) for disengagement thereof from the top edge of the printed circuit(s) (12) so as to obtain tipping through the force of gravity of the printed circuit(s) (12) onto the conveyor belt (18).
